# EUROPÄISCHE PATENTSCHRIFT

(11) **EP 1 959 721 B1**
(45) Veröffentlichungstag und Bekanntmachung des Hinweises auf die Patenterteilung: **02.03.2011**
(21) Anmeldenummer: 07123209.4
(22) Anmeldetag: 14.12.2007
(51) Int. Cl.: H05K 13/02

(54) **Modulare Flächenmagazin-Bereitstellungsvorrichtung für Bestücksysteme**
Modular pallet table preparation device for loading systems
Dispositif de préparation de magasins de surface modulaire pour systèmes d'implantation

(30) Priorität: 16.02.2007 DE 102007007819
(43) Veröffentlichungstag der Anmeldung: 20.08.2008
(73) Patentinhaber: Siemens Electronics Assembly Systems GmbH & Co. KG, 81379 München (DE)
(72) Erfinder: Fichtner-Pflaum, Gerolf, 76703 Kraichtal (DE); Heuberger, Franz, 69126 Heidelberg (DE); Krämer, Frank, 76646 Bruchsal (DE); Müller, Werner, 83607 Holzkirchen (DE); Stützer, Roland, 64653 Lorsch (DE)

(56) Entgegenhaltungen:
- JP-A- 2000 263 343
- JP-A- 2000 263 345
- US-A- 5 380 138
- US-A- 5 645 392

## Beschreibung

Die vorliegende Erfindung betrifft das Gebiet der automatischen Bestückung von Bauelementeträgern mit elektronischen Bauelementen. Die vorliegende Erfindung betrifft insbesondere die Zuführung von Flächenmagazinen, in denen jeweils eine Vielzahl von elektronischen Bauelementen abgelegt ist, für einen Bestückautomaten, so dass die Bauelemente von einem Bestückkopf des Bestückautomaten aus dem jeweiligen Flächenmagazin entnommen und in bekannter Weise auf einen zu bestückenden Bauelementeträger aufgesetzt werden können.

Die Bestückung von Bauelementeträgern bzw. Leiterplatten mit elektronischen Bauelementen erfolgt üblicherweise mittel sog. Bestückautomaten. Dabei werden die Bauelemente von einer Bauelement-Zuführeinrichtung an bestimmten Abholpositionen bereitgestellt und von dort von einem Bestückkopf abgeholt. Der Bestückkopf kann eine oder auch mehrere Bauelement-Haltevorrichtungen aufweisen, so dass gleichzeitig ein oder mehrere Bauelemente transportiert werden können. Der Bestückkopf kann mittels eines Positioniersystems innerhalb eines vorgegebenen Arbeitsbereiches positioniert werden. Nach dem Abholen werden die Bauelemente von dem Bestückkopf zu einer Bestückposition transportiert und auf dem zu bestückenden Substrat an durch entsprechende Anschlussflächen definierte Einbaupositionen aufgesetzt.

Das Zuführen der elektronischen Bauelemente für einen Bestückprozess kann auf verschiedene Arten erfolgen. So können beispielsweise Bauelemente, die in Taschen von so genannten Bauelement-Gurten verpackt sind, durch ein schrittweises Abwickeln eines Bauelement-Gurtes zeitlich nacheinander an einer vorgegebenen Abholposition bereitgestellt werden.

Außerdem können Bauelemente, die in einem Flächenmagazin bevorzugt in Form eines zweidimensionalen Rasters aufbewahrt werden, durch ein einfaches Bereitstellen des Flächenmagazins in einem Bereich neben dem eigentlichen Bestückfeld eines Bestückautomaten dem Bestückprozess zugeführt werden. In diesem Fall werden die einzelnen elektronischen Bauelemente von dem Bestückkopf des Bestückautomaten jeweils an einer anderen Abholposition aufgenommen. Die Bereitstellung von Bauelementen mittels eines geeigneten Flächenmagazins hat den Vorteil, dass im Vergleich zu einer Bereitstellung mittels eines Bauelement-Gurtes deutlich weniger Abfall produziert wird. Anders als die entleerten Bauelement-Gurte können die Flächenmagazine nämlich unter Umständen sogar wieder verwendet werden. Dies ist bei einem Gurt nicht möglich, der beim Zuführen üblicherweise sukzessive in einzelne Gurtstücke geschnitten wird.

Bei der Bauelement-Zuführung mittels Flächenmagazinen, in denen jeweils eine Mehrzahl von Bauelementen aufbewahrt sind, können gleichzeitig mehrere Flächenmagazine vertikal gestapelt in einem entsprechenden Container aufbewahrt werden. Währen des Bestückbetriebs werden die Flächenmagazine nacheinander aus dem Container entnommen und die darin aufbewahrten Bauelemente dem Bestückprozess bereit gestellt.

Die EP 1344441 offenbart einen Container für Flächenmagazine für elektronische Bauelemente. Der Container ermöglicht eine Platz sparende Anordnung von mehreren Flächenmagazinen in Form eines Stapels. Der Container weist einen Rahmen auf, der an den Außenecken vier Pfosten und äußere Seitenplatten umfasst. Die Flächenmagazine können aus zwei um 90° gegeneinander versetzten Richtungen in den Container eingeführt und von diesem entnommen werden. Trennplatten im Inneren des Containers können in verschiedenen Positionen angebracht werden, so dass eine variable Aufteilung des Containers in verschiedene Unterbereiche zur Aufnahme von unterschiedlich hohen Flächenmagazinen möglich ist. Der Container kann mittels eines Lifts auf verschiedenen Arbeitshöhen angehoben oder abgesenkt werden.

Die US 6,616,401 B2 offenbart eine Zuführeinrichtung für in Flächenmagazinen aufbewahrte elektronische Bauelemente. Die Zuführeinrichtung weist einen Lift auf, mit dem ein Flächenmagazin aus unterschiedlichen Höhenlagen aus einem Container herausgezogen und in eine Abholebene angehoben werden kann. Aus dieser Abholebene werden die Bauelemente dann von einem Bestückkopf aufgenommen und auf eine in der gleichen Ebene angeordnete Leiterplatte bestückt. Nach einer zumindest teilweisen Entleerung des in die Abholebene angehobenen Flächenmagazins wird dieses von dem Lift in einen Entladebereich der Zuführeinrichtung transferiert. Die genannte Zuführeinrichtung hat jedoch den Nachteil, dass beim Bereitstellen eines neuen Flächenmagazins zunächst das alte Magazin von der Abholebene entfernt und in den Entladebereich transferiert werden muss, bevor der Lift zum Herausnehmen eines neuen Flächenmagazins und zum Anheben desselben in die Abholebene zur Verfügung steht.

Die US 6,199,272 B1 offenbart eine Zuführeinrichtung für in Flächenmagazinen aufbewahrte elektronische Bauelemente. Die Zuführeinrichtung weist dabei eine Speichereinrichtung für Flächenmagazine auf, in welcher die Flächenmagazine vertikal übereinander gespeichert sind. Diese Speichereinrichtung kann mittels eines Hebemechanismus in vertikaler Richtung bewegt werden, um ein gewünschtes Flächenmagazin auf eine gewünschte Arbeitshöhe (z.B. Abholebene) zu bringen. Weiters weist die in der US 6,199,272 B1 offenbarte Zuführeinrichtung eine Einrichtung auf, mit welcher ein Flächenmagazin, welche von der Speichereinrichtung auf die Abholebene gebracht wurde, aus dem Speicher entnommen und zu einer Abholposition gebracht werden. Die genannte Zuführeinrichtung hat jedoch den Nachteil, dass ein Austauschen von Flächenmagazinen in der Speichereinrichtung nicht auf einfache Weise und zwischen Bestückungsvorgängen (d.h. bei einem Umrüsten) möglich ist.

US-A-5380138 offenbart eine Vorrichtung zum Bereitstellen von Flächenmagazinen mit einem Grundgestell, welches ein Chassis und eine Speichereinrichtung für übereinander angeordnete Flächenmagazine aufweist, wobei die Speichereinrichtung relativ zum Chassis vertikal verschiebbar ist, so dass jeweils ein gespeichertes Flächenmagazin auf eine vorgegebene Arbeitshöhe bringbar ist, einer Bereitstellungsvorrichtung zum Bereitstellen eines Flächenmagazins innerhalb eines Bereitstellungszeitraums, welches Flächenmagazin vor und nach dem Bereitstellungszeitraum zumindest vorübergehend in der Speichereinrichtung speicherbar ist, sowie einem verfahrbaren Ladevorrichtung zum Beladen der Speichereinrichtung mit Flächenmagazinen.

Der Erfindung liegt daher die Aufgabe zugrunde, auf einfache Weise die Bereitstellung von Flächenmagazinen für verschiedene Typen von Bestückautomaten zu verbessern und ein einfaches und sicheres Ein- und Ausschleusen von Flächenmagazinen zu ermöglichen.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Patentanspruch 1 wird eine Vorrichtung zum Bereitstellen von Flächenmagazinen beschrieben, welche insbesondere zum temporären Bereitstellen von mit elektronischen Bauelementen beladenen Flächenmagazinen für einen Bestückautomaten zum Zwecke der automatischen Bestückung von Bauelementeträgern mit elektronischen Bauelementen geeignet ist. Die beschriebene Flächenmagazin-Bereitstellungsvorrichtung weist auf (a) ein Grundmodul, welches ein Chassis und eine Speichereinrichtung für übereinander angeordnete Flächenmagazine aufweist, wobei die Speichereinrichtung relativ zu dem Chassis vertikal verschiebbar ist, so dass jeweils ein gespeichertes Flächenmagazin auf eine vorgegebene Arbeitshöhe bringbar ist. Die Flächenmagazin-Bereitstellungsvorrichtung weist ferner auf (b) ein Bereitstellungsmodul zum Bereitstellen eines Flächenmagazins innerhalb eines Bereitstellungszeitraums, welches Flächenmagazin vor und nach dem Bereitstellungszeitraum zumindest vorübergehend in der Speichereinrichtung speicherbar ist. Erfindungsgemäß ist das Bereitstellungsmodul mit dem Grundmodul kuppelbar. Weiters weist die Flächenmagazin-Bereitstellungsvorrichtung zusätzlich (c) ein Lademodul zum Beladen und Entladen der Speichereinrichtung mit Flächenmagazinen auf, wobei das Lademodul ebenfalls mit dem Grundmodul kuppelbar ist. Die Kupplung kann dabei entweder unmittelbar oder mittelbar erfolgen.

Der beschriebenen Flächenmagazin-Bereitstellungsvorrichtung liegt die Erkenntnis zugrunde, dass durch eine modulare Bauweise eine Konfigurierbarkeit der gesamten Flächenmagazin-Bereitstellungsvorrichtung geschaffen wird, so dass einem Kunden wie beispielsweise dem Betreiber einer Bestücklinie eine optimale Anpassung der Flächenmagazin-Bereitstellungsvorrichtung an ggf. verschiedene Bestückautomaten angeboten werden kann. Eine Konfigurierbarkeit kann beispielsweise dadurch erreicht werden, dass der Kunde aus mehreren verschiedenen Modulvarianten eine bevorzugte Modulvariante auswählt.

Die beschriebene Flächenmagazin-Bereitstellungsvorrichtung umfasst somit verschiedene funktionale Einheiten, die jeweils mittels eines separaten Moduls realisiert werden können. Dabei können selbstverständlich auch mehrere funktionale Einheiten zu einem gemeinsamen Modul zusammengefasst werden. Die Module sind jedoch derart ausgebildet, dass sie durch andere Module ausgetauscht werden können, welche die gleiche oder zumindest eine ähnliche Funktionalität aufweisen.

Bevorzugt werden dem Kunden zumindest verschiedene Bereitstellungsmodule angeboten, welche in Bezug auf das Grundmodul jeweils eine Flächenmagazin-Bereitstellung in verschiedenen räumlichen Abständen von dem Grundmodul ermöglichen. Dies bedeutet, dass sich die unterschiedlichen Bereitstellungsmodule im Einbauzustand von dem Grundmodul insbesondere in horizontaler Richtung unterschiedlich weit weg erstrecken.

Unter dem Begriff "kuppelbar" ist in dieser Anmeldung zu verstehen, dass zumindest zwei an der Kupplung beteiligte Module auf einfache Weise derart zusammengefügt werden können, dass die entsprechende Kuppelverbindung zum einen hohe mechanische Festigkeit und zum anderen eine einfache Lösbarkeit aufweist. Dies bedeutet, dass der Arbeitsaufwand eines Technikers für den Zusammenbau der verschiedenen Module deutlich geringer ist als der Aufwand, der bei der Herstellung der einzelnen Module geleistet werden muss.

Unter dem Begriff "kuppelbar" kann eine unmittelbare mechanische Verbindung zwischen zwei unterschiedlichen Komponenten bzw. Modulen verstanden werden. Ebenso kann jedoch auch eine mittelbare mechanische Verbindung unter Einbeziehung eines beliebigen Bauteils verstanden werden.

Die Kuppelverbindung kann auf verschiedene Arten realisiert werden. So können beispielsweise ineinander greifende und zueinander komplementäre Konturen von Kuppelelementen, die jeweils an den beteiligten Modulen angebracht sind, für eine räumlich stabile relative Anordnung der Module zueinander verwendet werden. Dabei können die zusammenwirkenden Kuppelelemente durch Sicherungselemente wie beispielsweise Splinte, Sicherungsringe oder Sicherungsstifte gegen ein versehentliches Verschieben gesichert werden. Auch die Schwerkraft kann dazu beitragen, dass sich die relative räumliche Lage der beteiligten Module nicht ändert.

Die Kuppelverbindung kann jedoch auch mit herkömmlichen lösbaren Befestigungsmitteln wie beispielsweise Schrauben und Muttern realisiert werden. Entscheidend ist lediglich, dass der Aufwand zum Zusammensetzen und/oder zum Lösen der Kuppelverbindung im Vergleich zum Herstellungsaufwand der einzelnen Module so gering ist, dass ein modulweiser Zusammenbau der Flächenmagazin-Bereitstellungsvorrichtung an verschiedenen Orten wie beispielsweise am Einsatzort in einer Maschinenhalle von einem Techniker durchgeführt werden kann.

Die Kupplungsverbindung kann neben einer entsprechenden mechanischen Schnittstelle auch elektrische und/oder optische Schnittstellen aufweisen, über welche die beteiligten Module miteinander koppelbar sind. Eine elektrische Verbindung kann beispielsweise der elektrischen Stromversorgung von peripheren Modulen dienen. Für eine Datenschnittstelle beispielsweise zum Übertragen von Steuerungsdaten für die gesamte Flächenmagazin-Bereitstellungsvorrichtung kann eine elektrische und/oder eine optische Schnittstelle verwendet werden.

Die Verwendung eines speziellen Lademoduls hat den Vorteil, dass auf einfache und zugleich sichere Weise Flächenmagazine in die Speichereinrichtung eingeschleust und aus dieser ausgeschleust werden können. Ein Einschleusen von Flächenmagazinen ist nicht nur bei einem erstmaligen Beladen der Speichereinrichtung sondern auch bei einem Austausch von zumindest teilweise entleerten Flächenmagazinen erforderlich.

Das Lademodul kann dabei einen Ladeschacht aufweisen, aus dem verbrauchte Flächenmagazine entnommen und in den neue Flächenmagazine von einer Bedienperson eingelegt werden können. Der Ladeschacht kann einen mechanischen Schutzschild wie beispielsweise eine Abdeckklappe aufweisen, um ein versehentliches Hineingreifen einer Bedienperson in den Ladeschacht während eines Einschleus- und/oder eines Ausschleusvorgangs eines Flächenmagazins zuverlässig zu unterbinden.

Ein Austausch eines ersten Flächenmagazins beginnt typischerweise damit, dass das auszutauschende erste Flächenmagazin nach einer entsprechenden Bauelemententnahme von dem Bereitstellungsmodul in die Speichereinrichtung transferiert wird. Unmittelbar nach diesem Transfer wird ein zweites Flächenmagazin von der Speichereinrichtung in das Bereitstellungsmodul transferiert, so dass ein Bestückprozess ohne größere Unterbrechung durch eine Bauelement-Entnahme aus dem zweiten Flächenmagazin fortgesetzt werden kann. Das auszutauschende erste Flächenmagazin wird dann in das Lademodul transferiert. Dieser Transfer erfolgt bevorzugt genau dann, wenn Bauelemente aus dem zweiten Flächenmagazin entnommen werden. Das erste Flächenmagazin kann dann von einer Bedienperson aus dem Lademodul entnommen und gegen ein neues drittes Flächenmagazin ersetzt werden kann. Danach erfolgt ein Einschleusen des dritten Flächenmagazins aus dem Lademodul in die Speichereinrichtung, aus der es später bei Bedarf in das Bereitstellungsmodul transferiert wird.

Bevorzugt sind das Lademodul und das Bereitstellungsmodul in Bezug auf die Speichereinrichtung des Grundmoduls auf einander gegenüberliegenden Seiten angeordnet. Dies hat den Vorteil, dass sowohl ein Transfer von Flächenmagazinen zwischen dem Lademodul und der Speichereinrichtung als auch ein Transfer von Flächenmagazinen zwischen der Speichereinrichtung und dem Bereitstellungsmodul entlang einer gemeinsamen Zuführachse erfolgen kann. Damit kann die beschriebene modulare Flächenmagazin-Bereitstellungsvorrichtung auf vergleichsweise einfache Weise realisiert werden.

Gemäß einem weiteren Ausführungsbeispiel der Erfindung nach Anspruch 2 sind das Lademodul und das Bereitstellungsmodul mittels eines gemeinsamen Moduls realisiert. Dies hat den Vorteil, dass zwei funktionale ähnliche Komponenten zu einem gemeinsamen Modul zusammengefasst sind und so die Anzahl an Modulen reduziert wird. Dies hat ferner den Vorteil, dass der Zusammenbau der modularen Flächenmagazin-Bereitstellungsvorrichtung erleichtert wird.

Die beiden Module können eine gemeinsame Arbeits- bzw. Transportebene aufweisen, so dass das gemeinsame Lade- und Bereitstellungsmodul durch eine einzige Transportstrecke bzw. Zuführachse realisiert werden kann. Die gemeinsame Transportstrecke kann dabei eine Aussparung aufweisen, durch welche die Speichereinrichtung im zusammengebauten Zustand hindurchragt.

Gemäß einem weiteren Ausführungsbeispiel der Erfindung nach Anspruch 3 weist die Flächenmagazin-Bereitstellungsvorrichtung zusätzlich ein Zusatzzuführelement auf, welches mit dem Bereitstellungsmodul an einer der Speichereinrichtung abgewandten Seite kuppelbar ist.

Das beschriebene Zusatzzuführelement hat den Vorteil, dass die jeweilige Hublänge der gesamten Zuführachse auf einfache Weise vergrößert werden kann. Die Länge des Zusatzzuführelements bestimmt somit den zusätzlichen Horizontalen Hub, um welchen ein Flächenmagazin horizontal in Richtung eines Bestückautomaten verschoben werden kann. Das Zusatzzuführelement kann eine Auflageverlängerung für eine Flächenmagazin-Auflage sein. Die Auflageverlängerung kann ein einfaches Verlängerungsblech sein, welches in geeigneter Weise an das Bereitstellungsmodul ankuppelbar ist.

Gemäß einem weiteren Ausführungsbeispiel der Erfindung nach Anspruch 4 ist die Speichereinrichtung mit einem Hubantrieb und/oder mit einer dem Chassis zugeordneten Führung kuppelbar. Dies hat den Vorteil, dass die beschriebene Flächenmagazin-Bereitstellungsvorrichtung mit unterschiedlichen Containern angeboten werden kann, die jeweils eine Speichereinrichtung für Flächenmagazine darstellen und die auf einfache Weise lösbar mit dem Grundmodul verbunden werden können. Die unterschiedlichen Container können dabei unterschiedlich unterteilt sein, so dass abhängig von der Bauhöhe der einzulagernden Flächenmagazine ein Container mit einer geeigneten Unterteilung angeboten werden kann. Somit können auch unterschiedlich hohe Flächenmagazine in Form eines kompakten Stapels in einem geeigneten Container der Speichereinrichtung eingelagert werden.

Gemäß einem weiteren Ausführungsbeispiel der Erfindung nach Anspruch 5 weist das Bereitstellungsmodul einen Horizontalantrieb auf, welcher derart eingerichtet ist, dass ein bereit gestelltes Flächenmagazin schrittweise verschiebbar ist. Dies hat den Vorteil, dass die von einem Bestückkopf des Bestückautomaten zu entnehmenden Bauelemente, welche sich noch in dem Flächenmagazin befinden, in definierte Abholpositionen bewegt werden können. Auf diese Weise können die Verfahrwege des Bestückkopfes erheblich reduziert werden, so dass die Bestückleistung infolge von reduzierten Transportzeiten des Bestückkopfes erhöht wird.

Im Falle einer lediglich eindimensionalen Verschiebung des Flächenmagazins in Richtung eines entsprechenden Bestückautomaten liegen die Abholpositionen bevorzugt auf einer Reihe, die senkrecht zu der Verschieberichtung orientiert ist.

Die schrittweise Verschiebung kann ungeregelt oder geregelt erfolgen. Eine geregelte Verschiebung, welche einen höheren apparativen Aufwand in Bezug auf zu verwendende Sensorik erfordert, ermöglicht selbstverständlich eine größere Genauigkeit der Positionierung der Flächenmagazine. Bevorzugt erfolgt die Verschiebung in Schrittweiten, die kommensurabel zu dem Teilungsabstand der einzelnen Aufnahmen des Flächenmagazins sind.

Gemäß einem weiteren Ausführungsbeispiel der Erfindung nach Anspruch 6 weist die Vorrichtung zusätzlich ein Sockelmodul auf, welches mit der Unterseite des Chassis kuppelbar ist. Dies hat den Vorteil, dass je nach Arbeitshöhe der Bestückautomaten, mit denen Bauelemente aus einem bereitgestellten Flächenmagazin entnommen werden, ein geeignetes Sockelmodul bzw. Höhen-Aufrüstmodul angeboten werden kann. Somit kann auf einfache Weise eine optimale Höhenanpassung der gesamten Flächenmagazin-Bereitstellungsvorrichtung an verschieden hohe Bestückautomaten erreicht werden. Dabei ist unter der Höhe eines Bestückautomaten die Arbeitsebene zu verstehen, aus der die Bauelemente von dem Bestückkopf des jeweiligen Bestückautomaten abgeholt werden können.

Gemäß einem weiteren Ausführungsbeispiel der Erfindung nach Anspruch 7 weist die Vorrichtung zusätzlich ein Gehäusemodul auf, welches mit dem Grundmodul und/oder mit dem Bereitstellungsmodul kuppelbar ist und welches derart ausgebildet ist, dass es, sofern mit dem Grundmodul und/oder mit dem Bereitstellungsmodul gekuppelt, einen Hubschacht definiert, in welchem die Speichereinrichtung vertikal verfahrbar ist. Dies hat den Vorteil, dass die Bewegung der Speichereinrichtung in einem geschützten Raum stattfinden kann, so dass eine Beeinträchtigung der Hubbewegung der Speichereinrichtung beispielsweise durch Gegenstände, welche sich mit der Speichereinrichtung verklemmen könnten, zuverlässig verhindert wird.

Das Gehäusemodul kann dabei eine Verkleidung aufweisen, welche den Hubschacht vollständig oder lediglich teilweise umgibt. Ferner kann die Verkleidung eine Sicherheitstür aufweisen, so dass bei Bedarf der Hubschacht durch ein einfaches Öffnen dieser Tür inspiziert werden kann.

Gemäß einem weiteren Ausführungsbeispiel der Erfindung nach Anspruch 8 weist das Grundmodul eine Verkleidung auf. Dies hat den Vorteil, dass einer Verschmutzung des Innenbereichs des Grundmoduls auf einfache und zugleich effektive Weise vorgebeugt werden kann. So können empfindliche Komponenten der beschriebenen Flächenmagazin-Bereitstellungsvorrichtung wie beispielsweise der Hubantrieb, eine Steuerungseinrichtung oder eine Stromversorgung sowohl vor Verschmutzung als auch vor Beschädigungen geschützt werden.

Mit dem Anspruch 9 wird ein Bestücksystem zum Bestücken von Bauelementeträgern mit elektronischen Bauelementen beschrieben. Das beschriebene Bestücksystem weist auf (a) einen Bestückautomaten mit einen Bestückkopf zum Aufnehmen, Transportieren und Aufsetzen von elektronischen Bauelementen an vorgegebenen Positionen eines Bauelementeträgers, und (b) eine Flächenmagazin-Bereitstellungsvorrichtung gemäß einem der oben beschriebenen Ausführungsbeispiele. Dabei ist die Flächenmagazin-Bereitstellungsvorrichtung relativ zu einem Chassis des Bestückautomaten derart angeordnet, dass elektronische Bauelemente aus einem mittels der Flächenmagazin-Bereitstellungsvorrichtung bereitgestellten Flächenmagazin unter Verwendung des Bestückkopfes entnehmbar sind.

Dem beschriebenen Bestücksystem liegt die Erkenntnis zugrunde, dass die für einen Bestückprozess erforderlichen Bauelemente verschiedenen Bestückautomaten auf optimale Weise zugeführt werden können, indem eine mit geeigneten Modulen konfigurierte Flächenmagazin-Bereitstellungsvorrichtung verwendet wird.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Figur 1 zeigt in einer vertikalen Schnittebene ein Bestücksystem mit einem Bestückautomaten und einer modularen Flächenmagazin-Bereitstellungsvorrichtung, welche ein Grundmodul und ein gemeinsames Lade- und Bereitstellungsmodul umfasst.

Figur 2 zeigt eine perspektivische Darstellung der Zusammensetzung einer modularen Flächenmagazin-Bereitstellungsvorrichtung.

An dieser Stelle bleibt anzumerken, dass sich in der Zeichnung die Bezugszeichen von gleichen oder von einander entsprechenden Komponenten lediglich in ihrer ersten Ziffer unterscheiden.

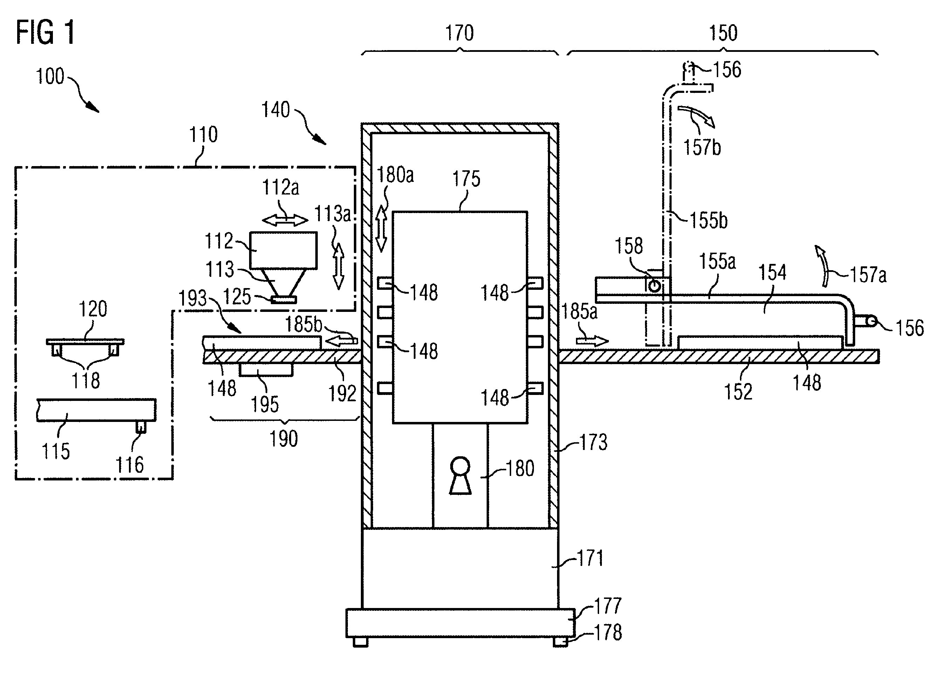

Figur 1 zeigt ein Bestücksystem 100 gemäß einem Ausführungsbeispiel der Erfindung in einer vertikalen Schnittebene. Das Bestücksystem 100 umfasst einen Bestückautomaten 110 und eine Flächenmagazin-Bereitstellungsvorrichtung 140.

Der Bestückautomat 110 weist einen Bestückkopf 112 auf, an dem eine als Saugpipette ausgebildete Bauelement-Haltevorrichtung 113 angebracht ist. Der Bestückkopf 112 ist mittels eines nicht dargestellten Positioniersystems relativ zu einem Chassis 115 des Bestückautomaten 110 entlang einer horizontalen Verschieberichtung 112a verschiebbar. Die Saugpipette 113 ist relativ zu dem Bestückkopf 112 entlang einer vertikalen Verschieberichtung 113a verschiebbar. Damit muss weder zum Aufnehmen eines Bauelements 125 noch zum Absetzen des Bauelements 125 auf einen Bauelementeträger 120 der gesamte Bestückkopf 112 abgesenkt bzw. angehoben werden.

Der Bestückautomat 110 weist ferner ein Transportsystem 118 auf. Das Transportsystem 118 kann ein übliches Förderband sein, mit dem in bekannter Weise Bauelementeträger 120 in einen Bestückbereich des Bestückautomaten 110 eingefahren und nach erfolgter Bestückung wieder aus dem Bestückbereich herausgefahren werden können.

An der Unterseite des Chassis 115 sind Maschinenfüße 116 angebracht, welche einen sicheren Stand des Bestückautomaten 110 auf einer nicht dargestellten Standfläche ermöglichen.

Die Flächenmagazin-Bereitstellungsvorrichtung 140 weist ein Lademodul 150, ein Grundmodul 170 und ein Bereitstellungsmodul 190 auf.

Das Lademodul 150 weist eine Auflage 152 auf, an dessen Oberseite ein Ladeschacht 154 angeordnet ist. Wie nachfolgend beschrieben wird, kann aus einem Container 175 des Grundmoduls 170 ein Flächenmagazin 148 in den Ladeschacht 154 transferiert werden. Das transferierte Flächenmagazin 148 kann dann von einer Bedienperson aus dem Ladeschacht 154 herausgenommen und gegen ein anderes Flächenmagazin ausgetauscht werden, welches nachfolgend in den Container 175 transferiert bzw. eingelagert werden kann.

Das Lademodul 150 weist ferner ein mechanisches Abschirmelement 155a auf, welches in einer geschlossenen Position verhindert, dass eine nicht dargestellte Bedienperson versehentlich in den Ladeschacht 154 hinein greift. Gemäß dem hier dargestellten Ausführungsbeispiel ist das mechanische Abschirmelement ein Schutzschild bzw. eine Abdeck-Klappe 155a, welche um eine Drehachse 158 schwenkbar ist. Das Bezugszeichen 155b bezeichnet die Abdeck-Klappe 155b in der Öffnungsposition. Ein Griff 156 an der Abdeck-Klappe 155a bzw. 155b erleichtert sowohl das manuelle Öffnen der Abdeck-Klappe 155a als auch das manuelle Schließen der Abdeck-Klappe 155b. Der Pfeil 157a verdeutlicht eine Öffnungsbewegung der Abdeck-Klappe 155a. Der Pfeil 157b verdeutlicht eine Schließbewegung der Abdeck-Klappe 155b.

In den Container 175, welcher auch als Speicherturm bezeichnet werden kann, können mehrere Flächenmagazine 148 ggf. zusammen mit einem nicht dargestellten Trägerelement übereinander eingeschoben werden können. Dazu sind eine Vielzahl von nicht dargestellten Führungsnuten vorgesehen, die entsprechend dem Prinzip einer Schublade ein einfaches horizontales Verschieben der Flächenmagazine 148 ermöglichen. Eine derartige stapelartige Anordnung der Flächenmagazine 148 hat den Vorteil, dass die Flächenmagazine 148 auf besonders Platz sparende Weise in dem Speicherturm 175 aufbewahrt werden können.

Aufgrund der modularen Bauweise der Flächenmagazin-Bereitstellungsvorrichtung 140 können abhängig von der Art der verwendeten Flächenmagazine unterschiedliche Container 175 verwendet werden. Dabei kann eine besonders kompakte Aufbewahrung insbesondere dann erreicht werden, wenn der Teilungsabstand der Führungsnuten an die jeweilige Höhe der Flächenmagazine 148 angepasst ist.

Das Grundmodul 170 weist ferner eine Hub- und Senkeinrichtung 180 auf, mittels welcher der Container 175 vertikal entlang der durch den Pfeil 180a dargestellten Bewegungsrichtung verschoben werden kann. Somit kann eine bestimmte Flächenmagazin-Speicherposition, die durch zwei in gleicher Höhe ausgebildete Führungsnuten definiert ist, auf die gleiche Höhe wie die Oberseite der Auflage 152 des Lademoduls 150 gebracht werden. Damit kann ein Flächenmagazin 148 durch eine einfache horizontale Verschiebebewegung 185a von dem Speicherturm 175 in den Ladeschacht 154 transferiert bzw. ausgeschleust werden. Das gleiche gilt selbstverständlich für einen Transfer bzw. ein Einschleusen eines in den Ladeschacht 154 eingelegten Flächenmagazins 148 in den Container 175.

Das Grundmodul 170 weist außerdem ein Chassis 171 auf. Bei einem entsprechenden Betrieb des Liftes 180 wird der Container 175 relativ zu dem Chassis 171 angehoben bzw. abgesenkt. Ein Gehäusemodul 173, welches an dem Chassis 171 lösbar befestigt ist, definiert einen Hubschacht, in welchem der Container 175 vertikal verfahrbar ist. Somit findet die Container-Bewegung in einem geschützten Raum statt.

Das Gehäusemodul 173 kann auf an der Innenseite mit so genannten Gleitleisten versehen sein, welche auch bei einer Hubbewegung des Containers 175 ein versehentliches Herausrutschen von Flächenmagazinen 148 aus dem Container 175 und/oder ein Verschieben in den Container 175 verhindern.

Das Chassis 171 des Grundmoduls befindet sich auf einem Sockelmodul 177. Das Sockelmodul 177 weist Maschinenfüße 178 auf, die einen sicheren Stand der gesamten Flächenmagazin-Bereitstellungsvorrichtung 140 auf einem nicht dargestellten Maschinenboden ermöglichen. Um die Arbeitshöhe der Bereitstellungsvorrichtung 140 optimal an ggf. unterschiedliche Arbeitshöhen von Bestückautomaten anpassen zu können, können einem Kunden verschieden hohe Sockelmodule 177 aus einem Höhen-Aufrüstsatz angeboten werden. Der Höhen-Aufrüstsatz kann verschiedene Varianten beispielsweise mit Höhen von 830 mm, 900 mm, 930 mm und 950 mm enthalten. Selbstverständlich können auch Sockelmodule 177 mit beliebig anderen Höhen verwendet werden.

Das Bereitstellungsmodul 190 weist eine Auflage 192 auf, welche auch Zuführachse bezeichnet wird. Auf der Zuführachse 192 kann jeweils ein Flächenmagazin 148 bereitgestellt werden, so dass die in dem Flächenmagazin 148 aufbewahrten Bauelemente 125 von dem Bestückkopf 112 des Bestückautomaten 110 entnommen werden können. Die Bereitstellung des jeweiligen Flächenmagazins 148 erfolgt an einer Bereitstellungsposition 193.

Das Bereitstellen eines Flächenmagazins 148 kann dabei eine erneute Hubbewegung 180a des Containers 175 umfassen, so dass sich am Ende der Hubbewegung 180a das entsprechende noch in dem Container 175 befindliche Flächenmagazin 148 auf der gleichen Höhe wie die Zuführachse 192 befindet. Damit kann ein Transfer dieses Flächenmagazins 148 durch eine weitere rein horizontale Verschiebung 185b erfolgen. Das gleiche gilt selbstverständlich auch für eine gegenläufige Verschiebebewegung von der Zuführachse 192 zurück in den Container 175.

Die Bereitstellungsposition 193 kann bei Bedarf mittels eines Horizontalantriebs 195 variiert werden, so dass das bereitgestellte Flächenmagazin 148 schrittweise verschoben werden kann. Damit können die zu entnehmenden elektronischen Bauelemente 125, welche sich noch in dem Flächenmagazin 148 befinden, vor dem Aufnehmen durch den Bestückkopf 112 in definierte Abholpositionen bewegt werden. Auf diese Weise können die Verfahrwege des Bestückkopfes 112 erheblich reduziert werden, so dass die Bestückleistung des Bestückautomaten 110 infolge von reduzierten Transportzeiten des Bestückkopfes erhöht wird.

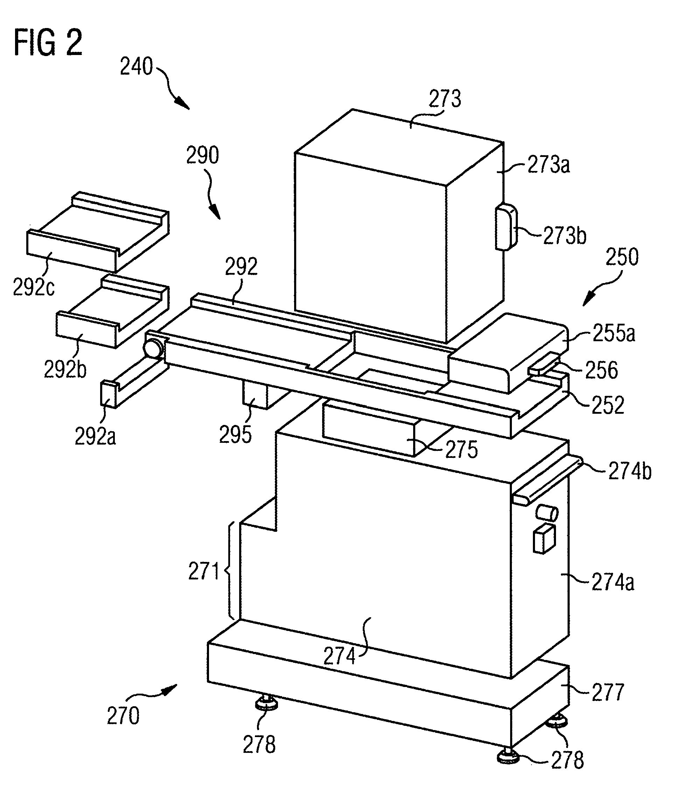

Figur 2 zeigt eine perspektivische Darstellung der Zusammensetzung einer modularen Flächenmagazin-Bereitstellungsvorrichtung 240. Die Flächenmagazin-Bereitstellungsvorrichtung 240 weist ein Grundmodul 270, ein Lademodul 250 mit einer Auflage 252 und ein Bereitstellungsmodul 290 mit einer Auflage 292 auf. Die Auflage 292 wird auch als Zuführachse 292 bezeichnet.

Gemäß dem hier dargestellten Ausführungsbeispiel ist das Lademodul 250 und das Bereitstellungsmodul 290 mittels eines gemeinsamen Moduls realisiert. Dieses Lade- und Bereitstellungsmodul 250, 290 ist lösbar mit einem Chassis 271 des Grundmoduls 270 verbunden.

An dem Lademodul 250 ist ein Ladeschacht ausgebildet, der ein mechanisches Abschirmelement 255a aufweist. Das mechanische Abschirmelement ist eine Abdeck-Klappe 255a, welche, wie oben bereits erläutert, ein sicheres Ein- und Ausschleusen von Flächenmagazinen gewährleistet. Ein Griff 256 dient dem bequemen Öffnen und Schließen der Abdeck-Klappe 255a.

An dem Bereitstellungsmodul 290 kann bei Bedarf ein Zusatzzuführelement 292a, 292b oder 292c angekuppelt werden. Die Zusatzzuführelemente 292a, 292b und 292c weisen jeweils eine andere Länge auf, so dass abhängig von der relativen Beabstandung eines in Figur 2 nicht dargestellten Bestückautomaten ein Zusatzzuführelement 292a, 292b oder 292c mit einer geeigneten Länge ausgewählt werden kann. Die Zusatzzuführelemente 292a, 292b und 292c, welche gemäß dem hier dargestellten Ausführungsbeispiel eine einfache Auflageverlängerung darstellen, können ebenfalls auf einfache Weise lösbar mit der Zuführachse 290 verbunden bzw. gekuppelt werden.

An dem Bereitstellungsmodul 290 ist ferner ein Horizontalantrieb 295 zum schrittweisen Verschieben von bereitgestellten Flächenmagazinen vorgesehen. Der Vorteil einer derartigen Horizontalverschiebung wurde bereits oben anhand von Figur 1 erläutert.

Das Grundmodul 270 weist einen Container 275 auf, in dem eine Mehrzahl von Flächenmagazinen in Form eines Stapels aufbewahrt werden können. Der Container 275 ist mittels eines nicht dargestellten Hubmotors relativ zu dem Chassis 271 vertikal verschiebbar, so dass durch eine entsprechende Hubbewegung jedes der gespeicherten Flächenmagazine auf die durch die Auflage 252 bzw. 292 definierte Arbeitshöhe gebracht werden kann. Somit können Flächenmagazine sowohl zwischen dem Lademodul 250 und dem Container 275 als auch zwischen dem Container 275 und dem Bereitstellungsmodul 290 durch eine einfache Horizontalbewegung transferiert werden.

Das Chassis 271 des Grundmoduls 270 kann auf einem Sockelmodul 277 abgestellt bzw. befestigt werden. Das Sockelmodul 277 weist Maschinenfüße 278 auf, die einen sicheren Stand der gesamten Flächenmagazin-Bereitstellungsvorrichtung 240 auf einem nicht dargestellten Maschinenboden ermöglichen. Durch die Wahl eines geeigneten Sockelmoduls 277 kann die Arbeitshöhe der gesamten Bereitstellungsvorrichtung 240 an die Arbeitshöhe eines Bestückautomaten angepasst werden.

Das Grundmodul 270 weist ferner eine Verkleidung 274 auf, in der eine Tür 274a ausgebildet ist. Die Tür 274a, welche einen Türgriff 274b aufweist, kann beispielsweise für eine Inspektion des Hubmotors geöffnet werden.

Außerdem weist das Grundmodul 270 ein Gehäusemodul 273 auf, welches lösbar an der gemeinsamen Auflage 252, 292 angebracht bzw. angekuppelt werden kann. Das Gehäusemodul 273 definiert einen Hubschacht, in welchem der Container 275 vertikal verfahrbar ist. Auch das Gehäusemodul 273 bzw. eine nicht näher bezeichnete Verkleidung des Gehäusemoduls 273 weist eine Tür auf, welche mit dem Bezugszeichen 273a versehen ist. Ein Türgriff 273b erleichtert das Öffnen der Tür 273a beispielsweise zu Inspektionszwecken des Hubschachts und/oder des darin befindlichen Containers 275.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

### Bezugszeichenliste

- 100: Bestücksystem
- 110: Bestückautomat
- 112: Bestückkopf
- 112a: Horizontalbewegung Bestückkopf
- 113: Haltevorrichtung / Saugpipette
- 113a: Vertikalbewegung Haltevorrichtung
- 115: Chassis
- 116: Maschinenfuß
- 118: Transportsystem
- 120: Bauelementeträger
- 125: Bauelement
- 140: Flächenmagazin-Bereitstellungsmodulvorrichtung
- 148: Flächenmagazin
- 150: Lademodul
- 152: Auflage
- 154: Ladeschacht
- 155a: mechanisches Abschirmelement / Schutzschild / Abdeck-Klappe (Schließposition)
- 155b: mechanisches Abschirmelement / Schutzschild / Abdeck-Klappe (Öffnungsposition)
- 156: Griff
- 157a: Öffnungsbewegung
- 157b: Schließbewegung
- 158: Drehachse
- 170: Grundmodul
- 171: Chassis
- 173: Gehäusemodul
- 175: Container / Speicherturm
- 177: Sockelmodul
- 178: Maschinenfuß
- 180: Hub- und Senkeinrichtung / Lift
- 180a: Hubbewegung
- 185a: Verschieberichtung Ausschleusen
- 185b: Verschieberichtung Bereitstellen
- 190: Bereitstellungsmodul
- 192: Auflage / Zuführachse
- 193: Bereitstellungsposition
- 195: Horizontalantrieb

- 240: modulare Flächenmagazin-Bereitstellungsvorrichtung
- 250: Lademodul
- 252: Auflage
- 255a: mechanisches Abschirmelement / Schutzschild / Abdeck-Klappe (Schließposition)
- 256: Griff
- 270: Grundmodul
- 271: Chassis
- 273: Gehäusemodul
- 273a: Tür
- 273b: Türgriff
- 274: Verkleidung
- 274a: Tür
- 274b: Türgriff
- 275: Container / Speicherturm
- 277: Sockelmodul
- 278: Maschinenfuß
- 290: Bereitstellungsmodul
- 292: Auflage / Zuführachse
- 292a: Zusatzzuführelement / Auflageelement
- 292b: Zusatzzuführelement / Auflageelement
- 292c: Zusatzzuführelement / Auflageelement
- 295: Horizontalantrieb

## Patentansprüche

1. Vorrichtung zum Bereitstellen von Flächenmagazinen (148), insbesondere zum temporären Bereitstellen von mit elektronischen Bauelementen (125) beladenen Flächenmagazinen (148) für einen Bestückautomaten (110) zum Zwecke der automatischen Bestückung von Bauelementeträgern (120) mit elektronischen Bauelementen (125), die Vorrichtung aufweisend
• ein Grundmodul (170, 270), welches ein Chassis (171, 271) und eine Speichereinrichtung (175, 275) für übereinander angeordnete Flächenmagazine (148) aufweist, wobei die Speichereinrichtung (175, 275) relativ zu dem Chassis (171, 272) vertikal verschiebbar ist, so dass jeweils ein gespeichertes Flächenmagazin (148) auf eine vorgegebene Arbeitshöhe bringbar ist,
• ein Bereitstellungsmodul (190, 290) zum Bereitstellen eines Flächenmagazins (148) innerhalb eines Bereitstellungszeitraums, welches Flächenmagazin (148) vor und nach dem Bereitstellungszeitraum zumindest vorübergehend in der Speichereinrichtung (175, 275) speicherbar ist, wobei das Bereitstellungsmodul (175, 275) mit dem Grundmodul (170, 270) kuppelbar ist, und
• ein Lademodul (150, 250) zum Beladen und Entladen der Speichereinrichtung (175, 275) mit Flächenmagazinen (148), wobei das Lademodul (150, 250) mit dem Grundmodul (170, 270) kuppelbar ist.

2. Vorrichtung nach Anspruch 1, wobei
das Lademodul (150, 250) und das Bereitstellungsmodul (190, 290) mittels eines gemeinsamen Moduls (150, 190, 250, 290) realisiert sind.

3. Vorrichtung nach einem der Ansprüche 1 bis 2, zusätzlich aufweisend
• ein Zusatzzuführelement (292a, 292b, 292c), welches mit dem Bereitstellungsmodul (290) an einer der Speichereinrichtung (275) abgewandten Seite kuppelbar ist.

4. Vorrichtung nach einem der Ansprüche 1 bis 3, wobei die Speichereinrichtung (175, 275) mit einem Hubantrieb (180) und/oder mit einer dem Chassis (171) zugeordneten Führung kuppelbar ist.

5. Vorrichtung nach einem der Ansprüche 1 bis 4, wobei das Bereitstellungsmodul (190, 290) einen Horizontalantrieb (195, 295) aufweist, welcher derart eingerichtet ist, dass ein bereit gestelltes Flächenmagazin (148) schrittweise verschiebbar ist.

6. Vorrichtung nach einem der Ansprüche 1 bis 5, zusätzlich aufweisend
• ein Sockelmodul (177, 277), welches mit der Unterseite des Chassis (171, 271) kuppelbar ist.

7. Vorrichtung nach einem der Ansprüche 1 bis 6, zusätzlich aufweisend
• ein Gehäusemodul (173, 273),
welches mit dem Grundmodul (170, 270) und/oder mit dem Bereitstellungsmodul (190, 290) kuppelbar ist und
welches derart ausgebildet ist, dass es, sofern mit dem Grundmodul (170, 270) und/oder mit dem Bereitstellungsmodul (190, 290) gekuppelt, einen Hubschacht definiert, in welchem die Speichereinrichtung (175, 275) vertikal verfahrbar ist.

8. Vorrichtung nach einem der Ansprüche 1 bis 7, wobei das Grundmodul (170, 270) eine Verkleidung (274) aufweist.

9. Bestücksystem zum Bestücken von Bauelementeträgern (120) mit elektronischen Bauelementen (125), das Bestücksystem aufweisend
• einen Bestückautomaten (110) mit einen Bestückkopf (112) zum Aufnehmen, Transportieren und Aufsetzen von elektronischen Bauelementen (125) an vorgegebenen Positionen eines Bauelementeträgers (120), und
• eine Vorrichtung (140, 240) nach einem der Ansprüche 1 bis 8.
wobei
die Vorrichtung (140, 240) relativ zu einem Chassis (115) des Bestückautomaten (110) derart angeordnet ist, dass elektronische Bauelemente (125) aus einem mittels der Vorrichtung (140, 240) bereitgestellten Flächenmagazin (148) unter Verwendung des Bestückkopfes (112) entnehmbar sind.

## Claims

1. Apparatus for providing trays (148), in particular for temporarily providing trays (148) loaded with electronic components (125) for a pick-and-place machine (110) for the purpose of automatically populating component carriers (120) with electronic components (125), said apparatus comprising
• a base module (170, 270) which has a chassis (171, 271) and a storage device (175, 275) for trays (148) disposed in a stacked arrangement, wherein the storage device (175, 275) can be displaced vertically relative to the chassis (171, 272) such that in each case a stored tray (148) can be moved to a predefined working height,
• a provisioning module (190, 290) for providing a tray (148) within a provisioning time period, which tray (148) can be stored at least temporarily in the storage device (175, 275) before and after the provisioning time period, wherein the provisioning module (175, 275) can be coupled to the base module (170, 270), and
• a load module (150, 250) for loading and unloading the storage device (175, 275) with trays (148), wherein the load module (150, 250) can be coupled to the base module (170, 270).

2. Apparatus according to claim 1, wherein
the load module (150, 250) and the provisioning module (190, 290) are implemented by means of a common module (150, 190, 250, 290).

3. Apparatus according to one of claims 1 to 2, additionally comprising
• an add-on feeder element (292a, 292b, 292c) which can be coupled to the provisioning module (290) on a side facing away from the storage device (275).

4. Apparatus according to one of claims 1 to 3, wherein the storage device (175, 275) can be coupled to a lift drive (180) and/or to a guide associated with the chassis (171).

5. Apparatus according to one of claims 1 to 4, wherein the provisioning module (190, 290) has a horizontal drive (195, 295) which is configured in such a way that a tray (148) which has been provided can be displaced incrementally.

6. Apparatus according to one of claims 1 to 5, additionally comprising
• a plinth module (177, 277) which can be coupled to the underside of the chassis (171, 271).

7. Apparatus according to one of claims 1 to 6, additionally comprising
• a housing module (173, 273),
which can be coupled to the base module (170, 270) and/or to the provisioning module (190, 290) and which is embodied in such a way that, when coupled to the base module (170, 270) and/or to the provisioning module (190, 290), it defines a lift shaft in which the storage device (175, 275) can be moved vertically.

8. Apparatus according to one of claims 1 to 7, wherein the base module (170, 270) has an enclosure (274).

9. Pick-and-place system for populating component carriers (120) with electronic components (125), the pick-and-place system comprising
• a pick-and-place machine (110) having a pick-and-place head (112) for picking up, transporting and placing electronic components (125) at predefined positions on a component carrier (120), and
• an apparatus (140, 240) according to one of claims 1 to 8, wherein
the apparatus (140, 240) is disposed relative to a chassis (115) of the pick-and-place machine (110) in such a way that the pick-and-place head (112) can be used to remove electronic components (125) from a tray (148) provided by means of the apparatus (140, 240).

## Revendications

1. Dispositif de mise à disposition de magasins plan (148), et plus particulièrement de mise à disposition temporaire de magasins plans (148) chargés de composants électroniques (125) pour un automate de pose (110) aux fins de la pose automatique de composants électroniques (125) sur des supports de composants (120), le dispositif comportant :
- un module de base (170, 270) qui comporte un châssis (171, 271) et un dispositif de stockage (175, 275) pour des magasins plans superposés (148), le dispositif de stockage (175, 275) étant déplaçable verticalement par rapport au châssis (171, 272) de sorte que respectivement un magasin plan stocké (148) peut être amené à une hauteur de travail prédéterminée ;
- un module de mise à disposition (190, 290) pour mettre à disposition un magasin plan (148) dans les limites d'une période de mise à disposition, lequel magasin plan (148) peut être stocké, avant et après la période de mise à disposition, au moins temporairement dans le dispositif de stockage (175, 275), le module de mise à disposition (175, 275) pouvant être couplé au module de base (170, 270), et
- un module de chargement (150, 250) pour charger le dispositif de stockage (175, 275) avec des magasins plans (148) et les en décharger, le module de chargement (150, 250) pouvant être couplé au module de base (170, 270).

2. Dispositif selon la revendication 1, le module de chargement (150, 250) et le module de mise à disposition (190, 290) étant réalisés au moyen d'un module commun (150, 190, 250, 290).

3. Dispositif selon l'une des revendications 1 à 2, comportant additionnellement un élément d'amenée supplémentaire (292a, 292b, 292c) qui peut être couplé au module de mise à disposition (290) sur un côté détourné du dispositif de stockage (275).

4. Dispositif selon l'une des revendications 1 à 3, le dispositif de stockage (175, 275) pouvant être couplé à un entraînement de levage (180) et/ou à un guidage associé au châssis (171).

5. Dispositif selon l'une des revendications 1 à 4, le module de mise à disposition (190, 290) comportant un entraînement horizontal (195, 295) qui est aménagé de manière telle qu'un magasin plan mis à disposition (148) peut être déplacé progressivement.

6. Dispositif selon l'une des revendications 1 à 5, comportant additionnellement un module socle (177, 277) qui peut être couplé à la face inférieure du châssis (171, 271).

7. Dispositif selon l'une des revendications 1 à 6, comportant additionnellement un module boîtier (173, 273) qui peut être couplé au module de base (170, 270) et/ou au module de mise à disposition (190, 290) et qui est réalisé de manière telle que, dans la mesure où il est couplé au module de base (170, 270) et/ou au module de mise à disposition (190, 290), il définit une cage de levage dans lequel le dispositif de stockage (175, 275) peut être déplacé verticalement.

8. Dispositif selon l'une des revendications 1 à 7, le module de base (170, 270) présentant un habillage (274).

9. Système de pose pour poser des composants électroniques (125) sur des supports de composants (120), le système de pose comportant
- un automate de pose (110) avec une tête de pose (112) pour prendre, transporter et apposer des composants électroniques (125) à des positions prédéterminées d'un support de composants (120) et
- un dispositif (140, 240) selon l'une des revendications 1 à 8,
le dispositif (140, 240) étant disposé de manière telle par rapport à un châssis (115) de l'automate de pose (110) que des composants électroniques (125) peuvent être prélevés d'un magasin plan (148) mis à disposition au moyen du dispositif (140, 240) en utilisant la tête de pose (112).
